# EUROPEAN PATENT SPECIFICATION

(11) **EP 3 231 009 B1**
(45) Date of publication and mention of the grant of the patent: **07.07.2021**
(21) Application number: 15867731.0
(22) Date of filing: 08.12.2015
(51) Int. Cl.: H01L 21/673, B65D 85/38

(54) **HORIZONTAL SUBSTRATE CONTAINER WITH INTEGRAL CORNER SPRING FOR SUBSTRATE CONTAINMENT**
HORIZONTALER SUBSTRATBEHÄLTER MIT INTEGRIERTER ECKFEDER FÜR SUBSTRATAUFNAHME
CONTENANT DE SUBSTRATS HORIZONTAUX À RESSORT DE COIN INCORPORÉ POUR CONFINEMENT DE SUBSTRATS

(30) Priority: 08.12.2014 US 201462089103 P
(43) Date of publication of application: 18.10.2017
(73) Proprietor: Entegris, Inc., Billerica, MA 01821 (US)
(72) Inventor: KIRKLAND, Eric, A., Colorado Springs, CO 80919 (US)
(74) Representative: Viering, Jentschura & Partner mbB Patent- und Rechtsanwälte
(86) International application number: PCT/US2015/064483
(87) International publication number: WO 2016/094398

(56) References cited:
- WO-A1-2009/048456
- WO-A2-2007/092557
- US-A- 5 402 890
- US-A- 5 553 711
- US-A1- 2002 014 435
- US-A1- 2006 201 847
- US-A1- 2006 201 847
- US-A1- 2010 224 517
- US-A1- 2011 049 006
- US-A1- 2014 034 548
- US-B1- 6 286 684
- US-B2- 7 138 726

## Description

### CROSS-REFERENCE TO RELATED APPLICATION

This application claims the benefit of U.S. Provisional Patent Application No. 62/089,103, filed on December 8, 2014.

### BACKGROUND

In general, substrate containers or carriers are used for transporting and/or storing batches of substrates such as silicon wafers or magnetic disks, before, during and after processing of the substrates. The substrates can be processed into integrated circuits and the disks can be processed into magnetic storage disks for computers. The terms wafer, disk, and substrate are used interchangeably herein and any of these terms can refer to semiconductor wafers, magnetic disks, flat panel substrates, and other such substrates, unless otherwise indicated.

Semiconductor wafers, from which integrated circuits and the like are manufactured, are conventionally round in shape and made from silicon, which is highly brittle. Such wafers are subjected to a variety of processing steps in transforming the semiconductor wafer into integrated circuit components. The various processing steps are performed under ultra-clean conditions to minimize the potential of contamination of the wafers as they are being processed. Each wafer may be subjected to dozens if not hundreds of steps in its processing cycle. The potential for contamination and destruction of a wafer or reduction in yield is ever present throughout the various processing and packaging steps. Particularly during the steps that take place at fabrication facilities, any minute particulates can destroy the integrated circuit on which it falls. Once the processing steps of the wafers are completed they are generally shipped while still in wafer form to a facility that will dice and capsulate in integrated circuit packaging each individual circuit on the wafer. The terms wafer containers, carriers, shippers, cassettes, transport/storage bins, and the like, are used interchangeably herein unless otherwise indicated.

Traditionally, during processing, storage and shipping of substrates, the substrates are supported and constrained at their edges to mitigate contact and possible damage and contamination to the faces of the substrates having the circuits thereon.

Even as substrates are getting larger in scale, up to 450 millimeters and greater in diameter, the density of components is getting significantly greater. Moreover, disks also are getting thinner providing much thinner completed integrated circuit packages. Accompanying the trend towards larger, denser, and thinner substrates, the substrates are becoming more valuable, more brittle, and more easily damaged during shipment. For thinner, more fragile substrates, enclosures are utilized in which the substrates are stacked on top of one another about a central axis.

US 2014/034548 A1 discloses a wafer container with flexible wall segments, panels or flexible inserts in the base member's main inner containment diameter, for reducing movement of semiconductor wafers within a wafer carrier. The walls allow a vertical containment surface to move and capture the entire stack of wafers, wherein a surface that contacts the wafers moves uniformly inward. The top and bottom cover may be assembled with use of ramped engagement surfaces in the top and/or bottom cover.

Commonly assigned U.S. Patent No. 7,040,487 to Zabka et al. (hereinafter "Zabka") discloses a protective shipper including a cover and a base that are held together by a latching mechanism. The base is configurable to protect semiconductor wafers or other substrates within a storage pocket. The base includes a support wall that defines the storage pocket, and the cover encloses the storage pocket. The cover includes one or more latching apertures configured to minimize unintended unlatching. Commonly assigned U.S. Patent No. 6,550,619 to Bores et al. (hereinafter "Bores") discloses another shipper having a base, a cover and a latching mechanism.

### SUMMARY

Various embodiments of the disclosure include a container that accommodates substrate stacks of varying height due to the accumulation of dimensional uncertainties associated with fabrication tolerances. That is, components within the substrate container are subject to dimensional uncertainty due to specified machining tolerances, for example, of thickness and flatness of support rings. The resulting dimensional uncertainties of these components result in what is herein referred to as "stack-up uncertainty." Rather than tightening the dimensional tolerance of the components, which would drive up fabrication costs, various embodiments of the disclosure describe substrate containers that readily accommodate a wide range of stack-up uncertainty.

For some embodiments of the disclosure, the same mechanism that enables the wide range of stack-up uncertainty also provides effective cushioning of the substrate carrier and its contents against shock.

Structurally, various embodiments of the disclosure present a substrate container or shipper that includes substrate supports, in the form of concentric rings, adapted to receive substrates in a stack. The container includes a base and a top cover to enclose the substrate stack. A latching mechanism is adapted to latch the base and top cover with respect to each other and secure the substrate stack within the container. The latching mechanism includes deflectable, biased corner flanges on an outside portion of the container, the flanges acting as springs to create load on the cover and on the substrate stack. The flanges hold the stack within the container while accommodating stack-up uncertainty. A gap is created between a side wall of the top cover and the base of the container. Deflection limiters prevent over-deflection of the flanges. Embodiments of the disclosure can be used with containers accommodating multiple different substrate sizes, for example 150 mm, 200 mm, 300 mm and 450 mm substrates, to name several examples. Other aspects will be apparent to those of ordinary skill upon reading this disclosure, and this Summary should not be considered limiting.

In various embodiments of the disclosure, a container for substrates defining a substrate storage area adapted to receive a plurality of stacked substrates is disclosed, the container including a base having an upwardly extending side wall, the side wall being disposed to at least partially surround the substrate storage area, the base further including at least one resilient latching member extending upwardly from the base, the latching member including an engagement portion having a substantially downwardly facing engagement surface. A cover includes a downwardly extending side wall, the cover cooperating with the base to at least partially surround the substrate storage area. At least one deflectable corner flange is operably coupled to the cover and extending radially outwardly relative to the side wall of the cover, the deflectable corner flange being constructed and arranged to be deflectable downwardly relative to the cover, the deflectable corner flange defining an aperture adapted to receive the latching member. The deflectable corner flange defines an upper surface adapted to engage the engagement portion of the latching member to latch the cover with respect to the base. A deflection limiter may be at least partially disposed on the latching member below the deflectable corner flange to engage and limit downward deflection of the deflectable corner flange.

In some embodiments, the at least one deflectable corner flange includes at least four deflectable corner flanges distributed around the cover, and the at least one latching member includes at least four latching members distributed around the base and generally aligned with the at least four corner flanges. The latching member may define a hook portion having a cam surface adapted to engage an edge of the aperture of the deflectable corner flange such that downward movement of the cover and corner flange together relative to the base applies force to the cam surface to bias the latching member toward a central axis of the container. In some embodiments, the corner flange is constructed and arranged such that deflection of the corner flange relative to the cover causes the hook portion to clear the aperture and causes the latching mechanism to snap radially outwardly to a latching position. The engagement portion of the latching member may engage the upper surface of the corner flange to latch the cover with respect to the base. In certain embodiments, the cam surface defines two cam surface portions adapted to engage said aperture edge, the two cam surface portions defining a gap therebetween. Each latching member may define a side surface and a base surface at an upper portion thereof, the side surface and the base surface being disposed to define the gap between the two cam surface portions. In some embodiments, the base surface defines a central opening defined at a bottom of the gap between the two cam surface portions. The central opening may be disposed directly above and in line with the deflection limiter. The corner flange may define a push pad adapted to receive downward force to deflect the corner flange. In some embodiments, the deflectable corner flange is molded as one-piece with the cover.

In various embodiments of the disclosure, a substrate container is disclosed, including a plurality of substrate supports adapted to receive substrates in a substrate stack within the container. First and second case portions define outer structure of the container and enclose the substrate supports. A latching mechanism is adapted to latch the first and second case portions with respect to each other and secure the substrate stack within the container. The latching mechanism includes a deflectable tab secured to and disposed at a radially outward position of the first case portion, the latching mechanism including a latching member secured to and disposed at a radially outward portion of the second case portion. The deflectable tab may define an opening therein, the opening adapted to receive the latching member to latch the first and second case portions together. In some embodiments, the deflectable tab is biased against the latching member to apply compressive force against the substrate stack through one of the case portions such that substrate stack is held fast within the first and second case portions.

The substrate stack may create a hard stop against movement of the first and second case portions with respect to each other. The substrate stack may also create a gap between the first and second case portions. In various embodiments, a deflection limiter is at least partially attached to the latching member to limit deflection of the tab. The deflection limiter may include a rib rotatable about a hinge disposed on the latching member, and a pocket defined by the deflectable tab adapted to receive the rotatable rib.

In various embodiments of the disclosure, a container for substrates in combination with a substrate stack is disclosed. The container includes a base having a perimeter and a side wall extending upwardly inside the perimeter and defining a storage pocket containing the substrate stack inside the side wall, the base including a pair of resilient latching members positioned between the perimeter and the side wall, each latching member having an upright portion with a hook portion having a downwardly facing engagement surface. In some embodiments, a cover has a perimeter and a side wall extending downwardly inside the perimeter, the cover being disposable on the base to enclose the storage pocket, the cover including deflectable flanges defining a pair of latching apertures. The flanges may each define a surface adapted to receive a respective downwardly facing engagement surface adjacent to the latching aperture, the latching apertures positioned between the perimeter of the cover and the side wall of the cover and corresponding to the pair of latching members, whereby when the pair of latching members are engaged with the cover at the pair of apertures, the cover is latched with respect to the base. In some embodiments, the substrate stack includes a plurality of substrates and a plurality of substrate supports. In some embodiments, the deflectable flanges are deflected when the cover is latched with respect to the base, the deflected flanges applying pressure to the latching members to draw the cover toward the base and to cause the cover to apply pressure to the stack to hold the stack within the container. In some embodiments, the cover contacts and applies compressive force against the stack, the stack adapted to stop the cover from movement toward the base when the cover is latched with respect to the base. The stack may be adapted to prevent the side wall of the cover from closing a gap between the base and the side wall of the cover when the cover is latched with respect to the base. The cover may press and seal against an uppermost substrate support when the cover is latched with respect to the base. The deflection of the flanges may accommodate stack-up uncertainty height variations from stack to stack. In some embodiments, the flange surface adapted to receive the respective downwardly facing engagement surface of the hook portion defines a latching recess within the flange. The latching recess may be angled downwardly with respect to a remainder of the flange, and the engagement surface of the hook portion is angled downwardly to correspond to the latching recess. The downward angle of the engagement surface and the downward angle of the latching recess are adapted to deflect the flange downwardly when the cover is latched with respect to the base.

In various embodiments of the disclosure, a combination of a container for substrates and a plurality of substrates is disclosed, the combination including a container base, a container cover, a plurality of substrate supports disposed within the container, and a plurality of substrates disposed substantially concentrically within the container on the substrate supports. A fastening mechanism may be adapted to secure the base and cover together and secure the plurality of substrates within the container, the fastening mechanism including a bendable flange coupled with the cover and bendable with respect to the cover, the bendable flange defining an aperture. The fastening mechanism may also including a biased fastening member connected to the base, the biased fastening member being constructed to extend through the aperture and spring into a fastening position within the aperture to fasten the cover with respect to the base. In some embodiments, the biased fastening member defining first and second engagement surfaces adapted to contact opposite sides of the bendable flange adjacent the aperture and limit bending of the bendable flange in opposite directions. In some embodiments, only one of the first and second engagement surfaces at a time is able to contact the bendable flange and limit bending of the bendable flange in a respective one of the opposite directions.

In various embodiments of the disclosure, the substrates are semiconductor wafers.

### BRIEF DESCRIPTION OF THE DRAWINGS

FIG. 1 is a perspective view of a substrate container, according to an embodiment of the disclosure;
FIG. 2 is a perspective cutaway view of the substrate container of FIG. 1;
FIG. 3 is a partially exploded view of the substrate container of FIG.1;
FIG. 4 is an upper perspective view of a latching member of the substrate container of FIG. 1;
FIG. 5 is a lower perspective view of the latching member of FIG. 4;
FIG. 6 is a lower perspective view of a latching mechanism of the substrate container of FIG. 1;
FIG. 7 is an upper perspective view of a deflectable flange of the substrate container of FIG. 1;
FIG. 8 is a perspective cross-sectional view of the deflectable flange of FIG. 7;
FIG. 9 is a partially cut-away side view of a latching mechanism of the substrate container of FIG. 1 in a radially inwardly biased position;
FIG. 10 is a partially cut-away side view of a latching mechanism of the substrate container of FIG. 1 in a latching position;
FIG. 11 is an upper perspective view of the latching mechanism of FIG. 10;
FIG. 12 is a partial cut-away side view of the substrate container of FIG. 1 in a pre-latched configuration;
FIG. 13 is a partial cut-away side view of the substrate container of FIG. 1 in a latched configuration;
FIG. 14 is a partially cut-away side view of a latching mechanism in a radially inwardly biased position, according to an embodiment of the disclosure;
FIG. 15 is a partially cut-away side view of a latching mechanism in a latching position, according to an embodiment of the disclosure;
FIG. 16 is a bottom perspective view of a deflection limiter according to an embodiment of the disclosure;
FIG. 17 is top perspective view depicting a feature of the limiter of FIG. 11; and
FIG. 18 is a bottom perspective view depicting the limiter of FIG. 11 in an alternate position.

### DETAILED DESCRIPTION

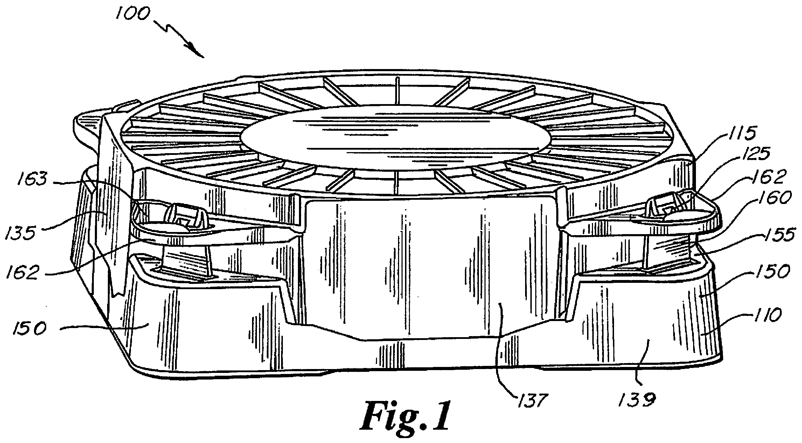

Referring to FIGS. 1-3, a container 100 is depicted in an embodiment of the disclosure. The depicted container 100 is a shipper for transporting, storing, and/or protecting 300 mm substrates 105 such as semiconductor wafers or other according to embodiments of the disclosure. The 300 mm shipper is depicted for illustrative purposes only, and it should be appreciated that shippers for smaller or larger substrates are included herein. The container 100 generally includes two cooperating portions, configured as a base 110 and a top cover 115. Top cover 115 enters into proximity with base 110 at interface region 120, and top cover 115 and base 110 are secured with respect to each other by latching mechanisms 125. Four latching mechanisms 125 are illustrated, but those of skill in the art will recognize that two, six, or any desired number of latching mechanisms are also contemplated in keeping with the disclosure.

Container 100 includes a plurality of substantially arcuate lateral substrate supports 130, in the form of generally concentric rings, for example, constructed to support substrates 105 in substrate stack 133 extending along central axis 134 of container 100. Supports 130 extend laterally inwardly relative to a generally cylindrical, downwardly extending, side wall 135 of cover 115. A non-limiting example of substrate supports 130 are disclosed, for example, at commonly assigned International Publication No. WO 2015/130690, published September 3, 2015.

Supports 130 may be molded or otherwise formed of plastic or other suitable material. In various embodiments, supports 130 are made of polypropylene. The supports 130 may be constructed of other materials including, but not limited to, polycarbonate or acetals. In some embodiments, the materials include a statically-dissipative filler, such as a carbon powder filler, for dissipation of static electricity.

Side wall 135 generally defines substrate stack pocket 138 for accommodating a substrate stack 133. Side wall 135 extends downwardly around an outside portion 137 of cover 115 and at least partially defines an outer perimeter 139 of cover 115. Floor 140 of container 100 is positioned at the bottom of pocket 138. Additionally, base 110 defines a side wall 145 extending upwardly around an outside portion of base 110 and is spaced inwardly from an outer periphery 146 of base 110. Side wall 145 may be generally arcuate or curved and is segmented into four side wall portions 147, according to the illustrated embodiment.

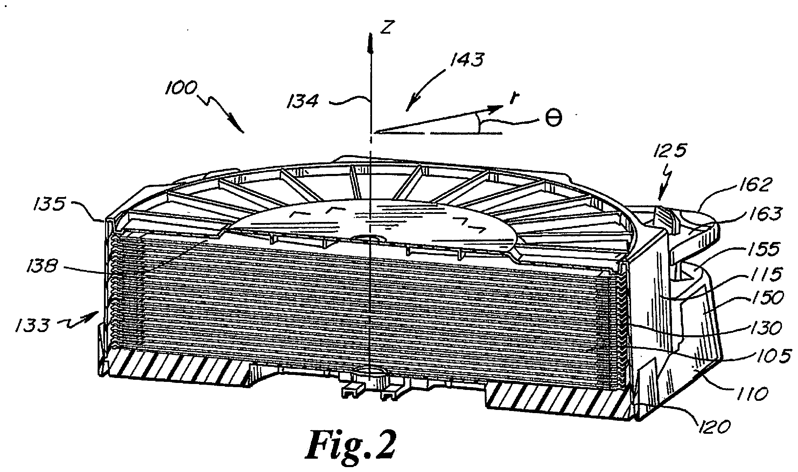

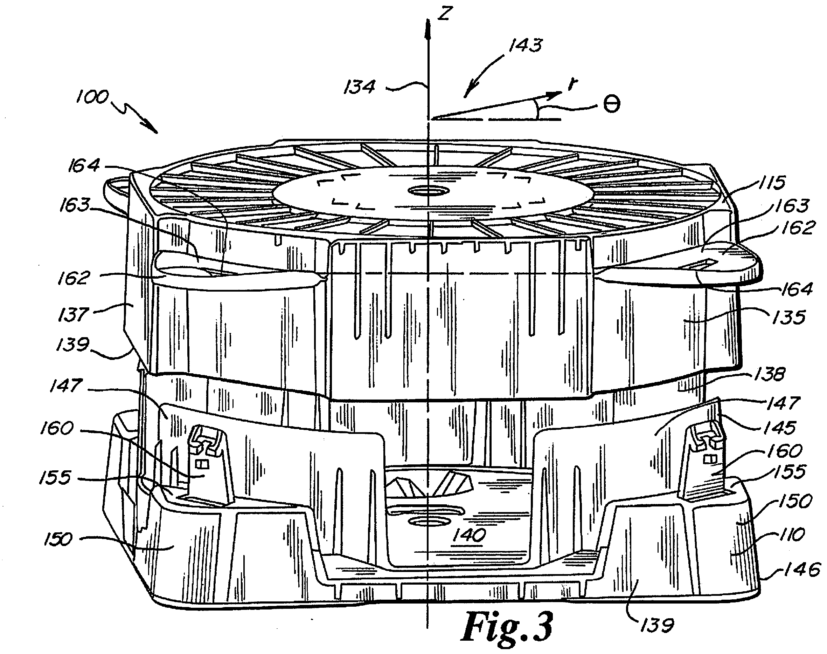

Herein, the terms "upward" and "upwardly" refer to a direction having a vector that extends in a positive z-direction, in accordance with a cylindrical coordinate system 143 of arbitrary origin (e.g., FIGS. 2 and 3). The terms "downward" and "downwardly" refer to a direction having a vector that extends in a negative z-direction, in accordance with the cylindrical coordinate system 143. The terms "outward" and "outwardly" refer to a direction having a vector that extends in a positive r-direction, in accordance with the cylindrical coordinate system 143. The terms "inward" and "inwardly" refer to a direction having a vector that extends in a negative r-direction, in accordance with the cylindrical coordinate system 143.

In some embodiments, base 110 defines protruding structure configured as shoulders 150, each defining an upper surface 155. Extending upwardly from upper surface 155 of each shoulder 150 is a latching member 160, constituting a portion of latching mechanism 125.

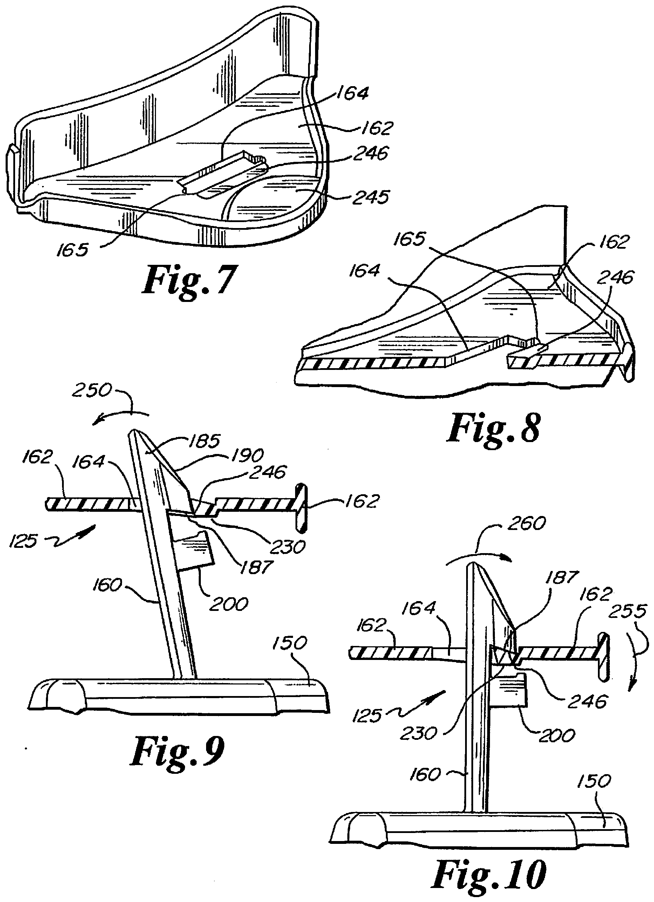

Cover 115 defines deflectable corner tabs or flanges 162, disposed directly above corresponding shoulders 150 and at least partially defining the outer perimeter 139 of cover 115. Flanges 162 are constructed and arranged to deflect downwardly with respect to a remainder of cover 115. In that regard, flanges 162 may be constructed free of ribs or other structural strengthening aspects that would tend to prevent or hinder such deflection. Flanges 162 each define an upper surface 163 and an aperture 164 for receiving a respective latching member 160, as will be described further, and thus form part of each latching mechanism 125. Each aperture 164 defines outdents 165, as described below in reference to FIGS. 7 and 8. Each deflectable corner flange 162 of cover 115 is formed or accommodated within a respective recess or groove 166 disposed in side wall 135. Although four sets of shoulders 150 and flanges 162 are illustrated, those of skill in the art will recognize upon reading this disclosure that two, six, or any desired number of sets are also contemplated in keeping with the disclosure.

In certain embodiments, shoulders 150 and latching members 160 are integrally molded as one piece with base 110, and deflectable flanges 162 are integrally molded as one piece with cover 115, according to aspects of the disclosure. Plastics or other materials suitable for molding or otherwise forming base 110, cover 115, and other components of container 100 will be apparent to those of ordinary skill upon reading this disclosure.

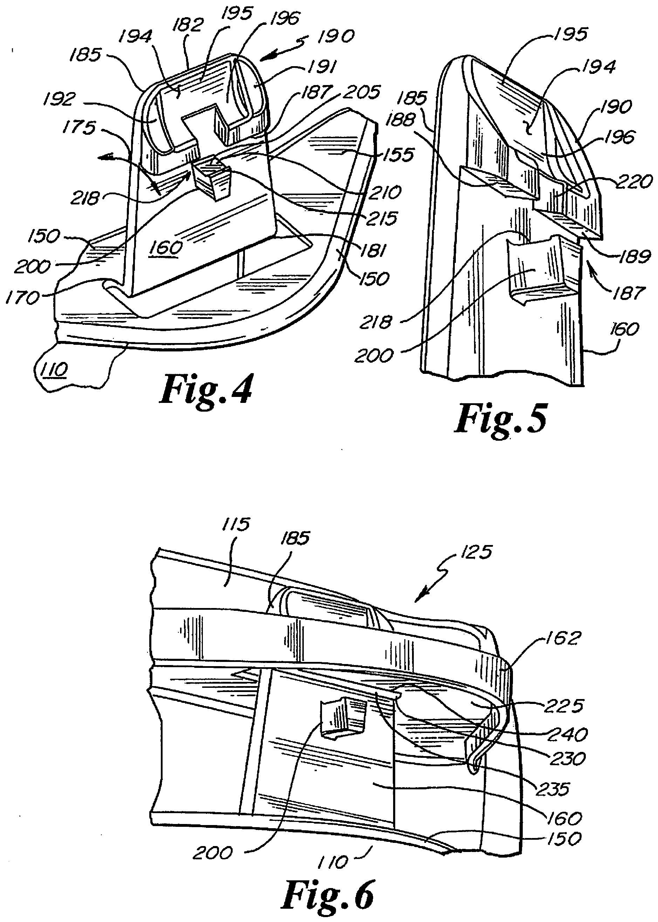

Referring additionally to FIGS. 4-6, latching member 160 of each latching mechanism 125 is disposed upright, or standing, and extends substantially upwardly with respect to shoulder 150 of base 110. Latching member 160 optionally defines a generally tapered shape bottom-to-top, being wider at a lower end 181 of base 110 than at an upper end 182, for easier insertion and locking within a corresponding latch opening or aperture 164. Latching member 160 may be connected to or molded with base 110 by substantially horizontal portion 170, which reduces a spring constant of latching member 160 in a generally vertical direction, i.e., in a direction generally parallel to central axis 134 of container 100, by allowing up and down flex of member 160. Member 160 is also generally flexible or rotatable in a radial direction with respect to container 100, generally transverse to central axis 134, as indicated by arrow 175, such that member 160 flexes radially inwardly from and radially outwardly to the as-molded position illustrated in FIG. 4.

In the depicted embodiments, the latching member 160 depicted as being actuated inwardly, toward the center of the container 100. It is noted that a latching member that is actuated outwardly is also contemplated, though not depicted.

Latching member 160 includes hook portion 185 having downwardly facing engagement surface 187. In some embodiments, such as depicted in FIG. 5, in the as-molded or unflexed position, engagement surface 187 angles downwardly with respect to the horizontal, i.e. downwardly with respect to upper surface 155 of shoulder 150 and upper surface 163 of flange 162. Engagement surface 187 may include two engagement surface portions 188, 189. In some embodiments, hook portion 185 also defines a cam surface 190, optionally formed as two cam surface portions 191, 192, that define an intervening gap 194. Gap 194 is bordered by generally upright surface 195 and generally curved base portion 196 of hook portion 185.

In various embodiments, each latching member 160 further includes deflection limiter or stop 200, which may be molded integrally as one piece therewith. Deflection limiter 200 may be disposed centrally along latching member 160 and includes a top engagement surface 205 having a base 210 and angled sides 215. Together, base 210 and sides 215 define an engagement pocket or recess 218. In various embodiments, deflection limiter 200 is tapered top to bottom, as depicted in FIG. 5. Deflection limiter 200 may be disposed directly below a gap 220 formed in curved base portion 196 of hook portion 185, to simplify mold tooling. Gap 220 avoids the need for mold action during formation of latching member 160, for example.

Bottom surface 225 (FIG. 6) of each deflectable flange 162 includes a protrusion or ridge 230 aligned with and extending along a width of aperture 164. Protrusion 230 includes a base 235 and side edges 240, which may correspond to base 210 and sides 215 of engagement recess 218 of deflection limiter 200.

Referring to FIGS. 7-8, an aperture 164 defined by each deflectable flange 162 of cover 115 is depicted in more detail according to an embodiment of the disclosure. Aperture 164 includes outdents or notches 165, creating a generally "T"-shaped aperture. Each flange 162 may also include push pad 245, raised with respect to a remainder of flange 162, for receiving downward force to deflect flange 162 with respect to a remainder of cover 115. Further, each flange 162 defines latching recess 246 for receiving engagement surface 187 of hook portion 185. Latching recess 246 is optionally sloped downwardly relative to the horizontal, or relative to upper surface 163 of flange 162, to receive corresponding downwardly sloped engagement surface 187 of hook portion 185. In some embodiments, the shape and slope of latching recess 246 matches the shape of protrusion 230 on bottom surface 225 of flange 162.

Functionally, and again in reference to FIGS. 4-6, forming hook portion 185 with two cam surface portions 191, 192, and two engagement surface portions 188, 189, separated by gap 194, as illustrated, helps maintain more consistent thickness of the plastic or other material forming hook portion 185, lessens the possibility of "sink" or other molding defects if gap 194 were filled in with material, and reduces potential rubbing contact between cam surface 190 and aperture 164, and between engagement surface 187 and upper surface 163 of flange 162, and consequent potential particulate generation, according to aspects of the disclosure. The corresponding shapes of the protrusion 230 and engagement recess 218 help guide protrusion 230 into engagement recess 218 upon downward deflection of flange 162 relative to the remainder of cover 115, as will be described. Outdents 165 of the generally "T"-shaped aperture tend to prevent unintended unlatching of latching mechanism 125 when cover 115 is rotated or otherwise inadvertently displaced with respect to base 110, or when latching member 160 receives unintended force. Latching member 160 has to receive a generally perpendicular unlatching force relative to central axis 134, and avoid outdents 165, for unlatching to occur. Further advantages of aperture 164 in this regard are described in U.S. Patent No. 7,040,487. Deflection limiters 200 substantially prevent each flange 162 from downward over-deflection. The distance between limiter 200 and bottom surface 225 of flange 162 is chosen to allow a desired amount of maximum deflection, depending, for example, on the thickness and material of flange 162. The distance between limiter 200 and that illustrated in the figures is not necessarily to scale. Limiter 200 creates a stop location for flange 162 to substantially prevent breakage, permanent deformation, an unacceptably loose latching fit, and other problems ultimately resulting from unlimited or excessive deflection of flange 162.

Limiting deflection has utility in both an operational and a non-operational context. In an operational context, when downward pressure is applied to push pad 245 to cause latching member 160 to snap into a latching position, for example, protrusion 230 will be received and stopped within engagement recess 218 of limiter 200 once a downward travel limit of flange 162 is reached. In a non-operational context, deflection limiter 200 may limit deflection of flange 162 that can occur when a latched container 100 is vacuum-sealed in plastic, for example, or subject to other external deflection forces, such as impact loads during shipping.

Referring to FIGS. 9-13 and again to FIG. 2, operation of container 100 is depicted in an embodiment of the disclosure. Substrate stack 133 is positioned initially within base 110 and/or cover 115 of container 100. Cover 115 is placed over base 110 for latching, such that latching members 160 enter respective apertures 164 within deflectable corner flanges 162. As cover 115 and thus flanges 162 are translated downwardly along central axis 134, cam surfaces 190 engage respective apertures 164 and deflect or rotate each latching member 160 inwardly toward central axis 134, as depicted by arrow 250. Hook portion 185 fills a substantial portion of aperture 164. A lower portion of cover 115, specifically a lower end of side wall 135, substantially enters interface region 120 between base 110 and cover 115. According to certain embodiments, a suitable upper internal portion of cover 115 is brought into contact with and engages wafer stack 133, specifically an uppermost concentric ring 130 thereof.

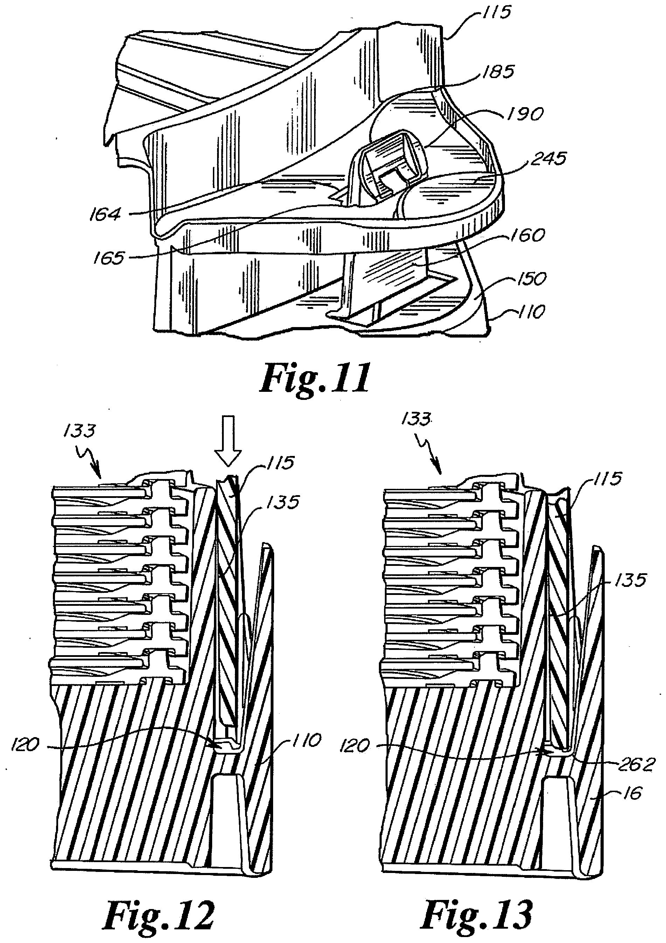

When flange 162 and latching member 160 are in an initial pre-latched position, as illustrated in e.g. FIG. 9, a user then applies downward force on push pads 245 (FIG. 11) or another portion of flange 162, causing downward deflection, bending or rotation of each flange 162 with respect to a remainder of cover 110, as indicated by arrow 255 in FIG. 10. Once continued deflection causes hook portion 185 to substantially clear aperture 164, the bias of latching member 160 towards its as-molded position causes latching member 160 to snap radially outwardly, as indicated by arrow 260. Downwardly facing engagement surface 187 of hook portion 185 slides over and into engagement with upper surface 163 of downwardly deflected flange 162, and is at least partially accommodated by correspondingly downwardly sloped latching recess 246. It should be noted that the precise downward slope in FIGS. 9-10 is not necessarily to scale, for purposes of illustration. FIG. 11 also depicts latching member 160 in its latched position.

Once latching member 160 reaches the latched position relative to flange 162 (FIGS. 10-11), the user releases the downward force on push pad 245, causing downwardly deflected flange 162 to at least partially spring upwardly, in a direction opposite to that indicated by arrow 255, and cause increased pressure and locking contact between flange 162 and engagement surface 187. The downwardly angled disposition of engagement surface 187 and deflection recess 246 optionally tends to maintain each flange 162 in a partially downwardly deflected position, thereby maintaining upwardly directed spring pressure by flanges 162 on hook portions 185 as the resilience of flanges 162 naturally tend to return to the as-molded position. Each flange 162 may remain partially deflected even when container 100 is in transport, for example, and the resulting deflection/spring force enhances and holds contact pressure of cover 115 relative to base 110. Cover 115 thus is pulled into tighter contact with respect to base 110 due to the continuous spring action of deflected flange 162.

To release cover 115 from latched contact with respect to base 110, a user presses inwardly on each latching member 160, in a direction opposite to arrow 260. In the case where flange 162 is still partially deflected, this inward pressure causes flange 162 to pop up relative to hook portion 185 and latching member 160, in a direction opposite to that of arrow 255, once engagement surface 187 moves completely into/over aperture 164 and clears recess 246 and upper surface 163 of flange 162. Compressive latching pressure between cover 115 and substrate stack 133, and/or between cover 115 and base 110, is thereby released, and cover 115 can be readily removed.

According to various embodiments of the disclosure, cover 115 exerts pressure directly on substrate stack 133, tending to press stack 133 into or toward floor 140 of container 100. Some embodiments of the disclosure create a compression force exerted on substrate stack 133 in a range of 5 lbf (pounds-force) to 10 lbf inclusive. Herein, a range that is said to be "inclusive" includes the end point values of the stated range. In some embodiments, the range of compressive force is 7 lbf to 9 lbf inclusive. Some embodiments create about 8 lbf of compression.

In some embodiments, due to tolerances or long term creep of the flanges 162, there may not always be a compression force applied by the flanges 162. This is acceptable functionally because, in certain embodiments, container 100 with substrate stack 133 assembled therein is shipped in a vacuum bag (not depicted) and or secondary foam packaging (not depicted). The vacuum bag/secondary packaging may maintain the container 100 in sufficient compression.

In one embodiment, cover 115 makes hard contact with an uppermost ring or support 130 of stack 133. As described in U.S. Provisional Patent Application No. 62/089,087, this hard contact may create a seal and an air cushion to protect stack 133 and especially the uppermost substrate 105 thereof. The larger the substrate diameter, especially 300 mm and greater diameter substrates, the more important it can be to protect the uppermost substrate in this manner. Stack 133 itself thus serves as a hard stop against cover 115, enhancing stability and security of substrate stack 133 within pocket 138 of container 100, without damaging individual substrates 105. U.S. Provisional Patent Application No. 62/089,087 is commonly assigned.

Additionally, stack-up uncertainty of the rings is easily accommodated due to the spring action of flanges 162. In an embodiment where stack 133 includes, for example, twenty six rings, a ring molding tolerance of a mere 0.001 in. (one one-thousandth of an inch) can result in relatively significant ring height and stack height variability from stack to stack, over the height of the entire stack. Such stack-up uncertainty thus can be, for example, on the order of about 0.026 in., or in the range of about 0.020 in. to about 0.032 in. inclusive, or in the range of about 0.026 in. to about 0.052 in. inclusive, or in a range of up to about 0.1 in. inclusive or more. Other stack-up uncertainties of greater or lesser dimension will be apparent to those of ordinary skill upon reading this disclosure. By building in deflection using corner flanges 162 of container 100, optionally in combination with horizontal portion 170 described previously, such uncertainty and variability is easily accommodated, allowing the previously mentioned air seal to be readily created.

Because cover 115 has a hard stop against, and generates compressive pressure on, stack 133, a small gap 262 may be created between cover 115 and base 110 in interface region 120 that exists even when cover 115 and base 110 are fully latched with respect to each other. Stack 133 is secured between and prevents the base 110 and cover 115 from moving closer to each other. In some embodiments, a gasket or seal assembly (not depicted) is disposed in the gap 262, making sealing contact with both the base 110 and the cover 115.

Referring to FIGS. 12-13, assembly of a loaded container 100 is depicted in an embodiment of the disclosure. In FIG. 12, cover 115 is moving into interface region 120. In FIG. 13, cover 115 compresses against stack 133 at the topmost portion thereof (e.g. FIG. 2), leaving gap 262 at the bottom of cover 115, and specifically at the lower end of side wall 135 thereof, where it would otherwise contact base 110. Gap 262 helps ensure that contact occurs between cover 115 and stack 133 instead between cover 115 and base 110, which could cause a looser fit and rattling of stack 133 within container 100, for example. Stack 133, cover 115, and base 110 thus all work together for protection and containment of substrates 105 against external impact shocks on container 100, for example caused by inadvertent dropping. Other related features and advantages are described in the above-identified commonly assigned US. 62/089,087. It should be noted that according to alternative embodiments, cover 115 can be pulled into direct contact with base 110 at interface region 120, and stack 133 can be secured tightly within container 100 using alternative methods.

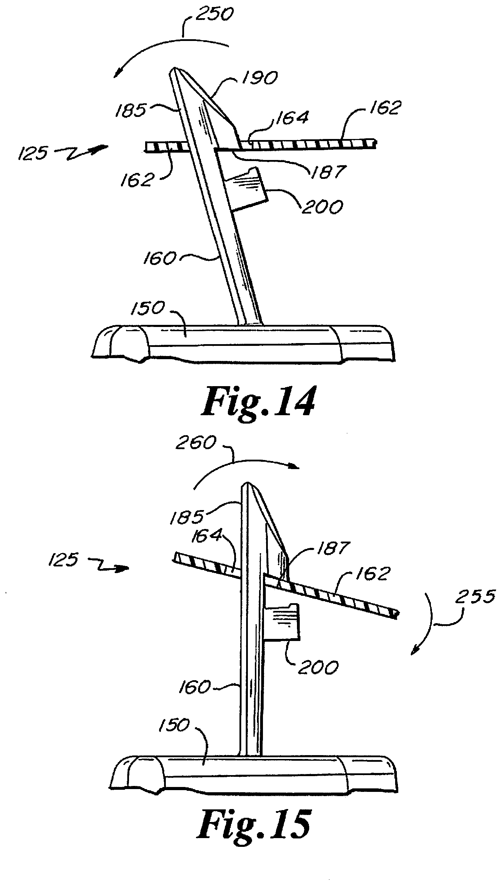

Referring to FIGS. 14-15, latching mechanism 125 is depicted according to an embodiment of the disclosure. For purposes of illustration, post-latched, in-use deflection of each flange 162 is not necessarily to scale. According to this embodiment, deflection recess 246 of FIGS. 9 and 10 is eliminated or reduced in depth, resulting in increased deflection angle relative to the deflection illustrated at FIG. 10. Conformance to the downwardly sloped engagement surface 187 may also cause local twisting of flange 162 as depicted. Other characteristics remain as described previously.

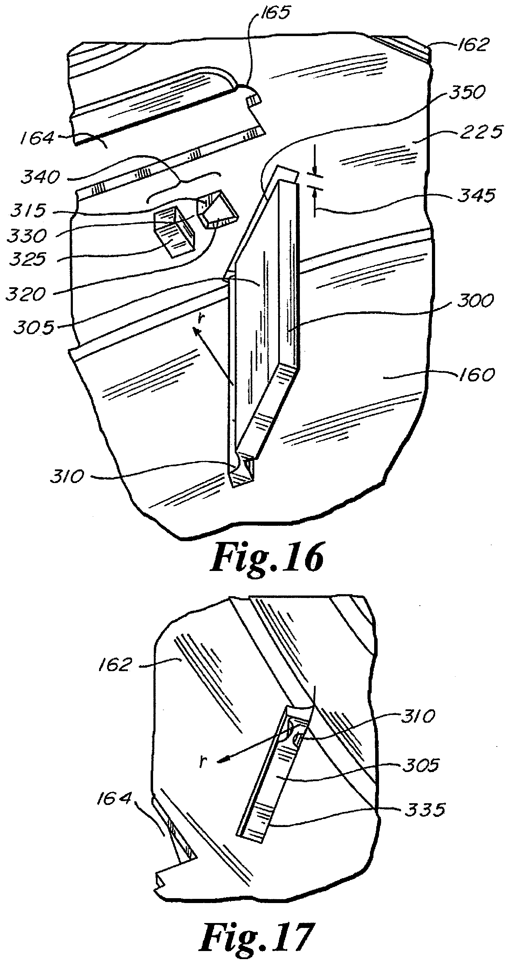

Referring to FIGS. 16-18, a deflection limiter 300 is depicted in an embodiment of the disclosure. Limiter 300 includes rib 305 that extends outward from cover 115 beneath flange 162. A registration structure 340 may be disposed on bottom surface 225 of flange 162 for securing rib 305 in a deployed orientation that is substantially aligned in the radial direction r. In the depicted embodiment, the registration structure 340 includes a ramp block 315 having an inclined surface 320, and a stop block 325. A slot 330 is defined between ramp block 315 and stop block 325, the slot 330 being sized to capture rib 305 between ramp block 315 and stop block 325.

In fabrication, rib 305 may be formed by use of a pass-through core (not depicted) in the portion of the mold that forms flange 162. The pass-through core provides a clearance 345 between bottom surface 225 of flange 162 and an upper edge 350 of rib 305. In some embodiments, an artifact of the pass-through core is a slot 335 defined in flange 162 that is aligned over rib 305 in the as-molded configuration.

Functionally, living hinge 310 enables selective, manual rotation of rib 305 with respect to latching member 160. Molded on bottom surface 225 of deflectable flange 162. Clearance 345 enables rib 305 to rotate, if needed, about the living hinge 310 for setting in the operative position. Clearance 345 also defines the amount of deflection that flange 162 will undergo before engaging limiter 300.

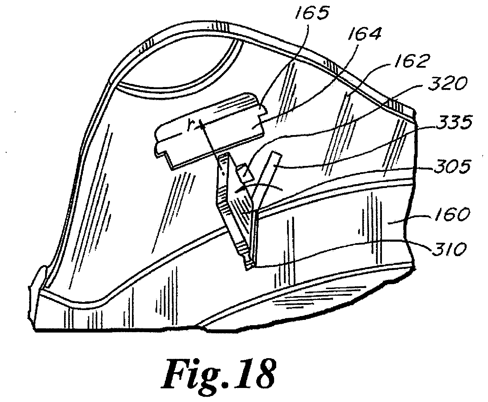

In use, an operator rotates rib 305 from its as-molded, initial position depicted in FIG. 16, sliding up and over ramp block 315, to clip into an operative position within slot 330 as depicted in FIG. 18. Deflection limiter 300 limits downward deflection of flange 162 substantially in a manner and with advantages described previously herein, with an additional advantage of optional deployment. The use of the pass-through core may also accurately provide a smaller deflection clearance between flange 162 and limiter 300 for tighter deflection control.

The embodiments described above are intended to be illustrative and not limiting. Additional embodiments are within the claims. Although the present disclosure describes particular embodiments, those skilled in the art will recognize that changes may be made in form and substance without departing from the scope of the invention which is defined by the appended claims.

Each of the additional figures and methods disclosed herein can be used separately, or in conjunction with other features and methods, to provide improved devices and methods for making and using the same. Therefore, combinations of features and methods disclosed herein may not be necessary to practice the disclosure in its broadest sense and are instead disclosed merely to particularly describe representative and preferred embodiments.

Various modifications to the embodiments may be apparent to one of skill in the art upon reading this disclosure. For example, persons of ordinary skill in the relevant arts will recognize that the various features described for the different embodiments can be suitably combined, un-combined, and re-combined with other features, alone, or in different combinations. Likewise, the various features described above should all be regarded as example embodiments, rather than limitations to the scope of the invention which is defined by the appended claims.

Persons of ordinary skill in the relevant arts will recognize that various embodiments can include fewer features than illustrated in any individual embodiment described above. The embodiments described herein are not meant to be an exhaustive presentation of the ways in which the various features may be combined. Accordingly, the embodiments are not mutually exclusive combinations of features; rather, the claims can include a combination of different individual features selected from different individual embodiments, as understood by persons of ordinary skill in the art.

References to "embodiment(s)", "disclosure", "present disclosure", "embodiment(s) of the disclosure", "disclosed embodiment(s)", and the like contained herein refer to the specification (text, including the claims, and figures) of this patent application that are not admitted prior art.

## Claims

1. A container (100) for substrates, the container (100) defining a substrate storage area adapted to receive a plurality of stacked substrates, the container (100) comprising:
a base (110) including an upwardly extending side wall (145), the side wall (145) being disposed to at least partially surround the substrate storage area, the base (110) including at least one resilient latching member (160) extending upwardly from the base (110), the latching member (160) including an engagement portion having a substantially downwardly facing engagement surface;
a cover (115) including a downwardly extending side wall (135), the cover (115) cooperating with the base (110) to at least partially surround the substrate storage area; and
at least one deflectable corner flange (162) operably coupled to the cover (115) and extending radially outwardly relative to the side wall (135) of the cover (115), the deflectable corner flange (162) being constructed and arranged to be deflectable downwardly relative to the cover (115), the deflectable corner flange (162) defining an aperture adapted to receive the latching member (160), the deflectable corner flange (162) defining an upper surface (163) adapted to engage the engagement portion of the latching member (160) to latch the cover (115) with respect to the base (110).

2. The container (100) of claim 1, wherein:
the at least one deflectable corner flange (162) includes at least four deflectable corner flanges distributed around the cover (115); and
the at least one latching member (160) includes at least four latching members distributed around the base (110) and generally aligned with the at least four corner flanges.

3. The container (100) of claim 1, wherein:
the latching member (160) defines a hook (185) portion having a cam surface adapted to engage an edge of the aperture of the deflectable corner flange (162) such that downward movement of the cover (115) and corner flange (162) together relative to the base (110) applies force to the cam surface to bias the latching member (160) toward a central axis of the container (100);
the corner flange (162) is constructed and arranged such that deflection of the corner flange (162) relative to the cover (115) causes the hook portion (185) to clear the aperture and causes the latching mechanism to snap radially outwardly to a latching position; and
the engagement portion of the latching member (160) engages the upper surface (163) of the corner flange (162) to latch the cover (115) with respect to the base (110).

4. The container (100) of claim 3, wherein the cam surface defines two cam surface portions adapted to engage said aperture edge, the two cam surface portions defining a gap therebetween.

5. The container (100) of claim 1, wherein the deflectable corner flange (162) is molded as one-piece with the cover (115).

6. The container (100) of claim 1, wherein the corner flange (162) defines a push pad adapted to receive downward force to deflect the corner flange (162).

7. The container (100) of any one of the previous claims, further comprising
a plurality of substrate supports (130) adapted to receive a plurality of substrates in a substrate stack, wherein the plurality of substrates form the plurality of stacked substrates, within the container (100).

8. The container (100) of claim 7, wherein the substrate stack creates a hard stop against movement of the base (110) and cover (115) with respect to each other.

9. The container (100) of claim 7, further comprising the substrate stack, and
wherein the substrate stack includes the plurality of substrates and the plurality of substrate supports (130).

10. The container (100) of claim 9, wherein the cover (115) contacts the substrate stack, the substrate stack being configured to stop the cover (115) from movement towards the base (110) when the cover (115) is latched with respect to the base (110).

11. The container (100) of any of the previous claims, wherein
the resilient latching member (160) defines a first and a second engagement surface adapted to contact opposite sides of the deflectable corner flange (162) adjacent the aperture and limit a bending of the deflectable corner flange (162) in opposite directions.

12. The container (100) of claim 11, wherein only one of the first and second engagement surfaces at a time is able to contact the deflectable corner flange (162) and limit bending of the deflectable corner flange (162) in a respective one of the opposite directions.

13. The container (100) of claim 11, wherein said substrates are semiconductor wafers.

## Patentansprüche

1. Ein Behälter (100) für Substrate, wobei der Behälter (100) einen Substratspeicherbereich definiert, der angepasst ist, um eine Vielzahl an gestapelten Substraten aufzunehmen, der Behälter (100) umfassend:
einen Boden (110) mit einer sich nach oben erstreckenden Seitenwand (145), wobei die Seitenwand (145) so angeordnet ist, dass sie den Substratspeicherbereich zumindest teilweise umgibt, wobei der Boden (110) mindestens ein elastisches Verriegelungselement (160) enthält, das sich von dem Boden (110) nach oben erstreckt, wobei das Verriegelungselement (160) einen Einrückabschnitt mit einer im wesentlichen nach unten gerichteten Einrückfläche umfasst;
eine Abdeckung (115) mit einer sich nach unten erstreckenden Seitenwand (135), wobei die Abdeckung (115) mit dem Boden (110) zusammenwirkt, um den Substratspeicherbereich zumindest teilweise zu umgeben; und
mindestens ein auslenkbarer Eckflansch (162), der betriebsbereit mit der Abdeckung (115) gekoppelt ist und sich radial nach außen relativ zur Seitenwand (135) der Abdeckung (115) erstreckt, wobei der auslenkbare Eckflansch (162) so konstruiert und angeordnet ist, dass er relativ zur Abdeckung (115) nach unten auslenkbar ist, wobei der auslenkbare Eckflansch (162) eine Öffnung definiert, die zur Aufnahme des Verriegelungselements (160) geeignet ist, und der auslenkbare Eckflansch (162) eine obere Oberfläche (163) definiert, die zum Einrücken in den Einrückabschnitt des Verriegelungselements (160) geeignet ist, um die Abdeckung (115) in Bezug auf den Boden (110) zu verriegeln.

2. Der Behälter (100) nach Anspruch 1, wobei:
der mindestens eine auslenkbare Eckflansch (162) mindestens vier auslenkbare Eckflansche umfasst, die um die Abdeckung (115) verteilt sind; und
das mindestens eine Verriegelungselement (160) mindestens vier Verriegelungselemente umfasst, die um den Boden (110) verteilt sind und im Allgemeinen mit den mindestens vier Eckflanschen ausgerichtet sind.

3. Der Behälter (100) nach Anspruch 1, wobei:
das Verriegelungselement (160) einen Hakenabschnitt (185) mit einer Nockenoberfläche definiert, die so ausgelegt ist, dass sie in eine Kante der Öffnung des auslenkbaren Eckflansches (162) einrückt, so dass eine nach unten gerichtete Bewegung der Abdeckung (115) zusammen mit dem Eckflansch (162) relativ zum Boden (110) eine Kraft auf die Nockenoberfläche ausübt, um das Verriegelungselement (160) in Richtung einer Mittelachse des Behälters (100) vorzuspannen;
der Eckflansch (162) so konstruiert und angeordnet ist, dass eine Auslenkung des Eckflansches (162) relativ zur Abdeckung (115) bewirkt, dass der Hakenabschnitt (185) die Öffnung freigibt und der Verriegelungsmechanismus radial nach außen in einer Verriegelungsposition einrückt; und
der Einrückabschnitt des Verriegelungselements (160) in die Oberseite (163) des Eckflansches (162) einrückt, um die Abdeckung (115) in Bezug auf den Boden (110) zu verriegeln.

4. Der Behälter (100) nach Anspruch 3, wobei die Nockenoberfläche zwei Nockenoberflächenabschnitte definiert, die zum Einrücken in die Öffnungskante geeignet sind, wobei die zwei Nockenoberflächenabschnitte einen Spalt dazwischen definieren.

5. Der Behälter (100) nach Anspruch 1, wobei der auslenkbare Eckflansch (162) mit der Abdeckung (115) einteilig geformt ist.

6. Der Behälter (100) nach Anspruch 1, wobei der Eckflansch (162) eine Stoßplatte definiert, die dazu ausgelegt ist, eine nach unten gerichtete Kraft aufzunehmen, um den Eckflansch (162) abzulenken.

7. Der Behälter (100) nach einem der vorhergehenden Ansprüche, ferner umfassend
eine Vielzahl an Substratträgern (130), die angepasst ist, um eine Vielzahl an Substraten in einem Substratstapel aufzunehmen, wobei die Vielzahl an Substraten die Vielzahl an gestapelten Substraten innerhalb des Behälters (100) bildet.

8. Der Behälter (100) nach Anspruch 7, wobei der Substratstapel einen harten Anschlag gegen Bewegung des Bodens (110) und der Abdeckung (115) in Bezug aufeinander erzeugt.

9. Der Behälter (100) nach Anspruch 7, ferner umfassend den Substratstapel, und
wobei der Substratstapel die Vielzahl von Substraten und die Vielzahl von Substratträgern (130) umfasst.

10. Der Behälter (100) nach Anspruch 9, wobei die Abdeckung (115) den Substratstapel berührt, wobei der Substratstapel konfiguriert ist, um zu verhindern, dass sich die Abdeckung (115) in Richtung des Bodens (110) bewegt, wenn die Abdeckung (115) in Bezug auf den Boden (110) verriegelt ist.

11. Der Behälter (100) nach einem der vorhergehenden Ansprüche, wobei
das elastische Verriegelungselement (160) eine erste und eine zweite Einrückfläche definiert, die dazu ausgelegt sind, gegenüberliegende Seiten des auslenkbaren Eckflansches (162) neben der Öffnung zu berühren und eine Biegung des auslenkbaren Eckflansches (162) in entgegengesetzte Richtungen zu begrenzen.

12. Der Behälter (100) nach Anspruch 11, wobei jeweils nur eine der ersten und zweiten Einrückflächen den auslenkbaren Eckflansch (162) berühren und Biegung des auslenkbaren Eckflansches (162) in jeweils einer der entgegengesetzten Richtungen begrenzen kann.

13. Der Behälter (100) nach Anspruch 11, wobei die Substrate Halbleiterwafer sind.

## Revendications

1. Un contenant (100) pour substrats, le contenant (100) définissant une zone de stockage de substrats conçue pour recevoir une pluralité de substrats empilés, le contenant (100) comprenant :
une base (110) comprenant une paroi latérale (145) s'étendant vers le haut, la paroi latérale (145) étant disposée de manière à entourer au moins partiellement la zone de stockage de substrats, la base (110) comprenant au moins un élément de verrouillage résilient (160) s'étendant vers le haut à partir de la base (110), l'élément de verrouillage (160) comprenant une partie de mise en prise ayant une surface de mise en prise orientée sensiblement vers le bas ;
un couvercle (115) comprenant une paroi latérale s'étendant vers le bas (135), le couvercle (115) coopérant avec la base (110) de manière à entourer au moins partiellement la zone de stockage de substrats ; et
au moins une bride de coin flexible (162) couplée de manière opérationnelle au couvercle (115) et s'étendant radialement vers l'extérieur par rapport à la paroi latérale (135) du couvercle (115), la bride de coin flexible (162) étant conçue et agencée de manière à pouvoir être défléchie vers le bas par rapport au couvercle (115), la bride de coin flexible (162) définissant une ouverture conçue pour recevoir l'élément de verrouillage (160), la bride de coin flexible (162) définissant une surface supérieure (163) conçue pour venir en prise avec la partie de mise en prise de l'élément de verrouillage (160) afin de verrouiller le couvercle (115) par rapport à la base (110).

2. Le contenant (100) de la revendication 1, dans lequel :
L'au moins une bride de coin flexible (162) comprend au moins quatre brides de coin flexibles réparties autour du couvercle (115) ; et
L'au moins un élément de verrouillage (160) comprend au moins quatre éléments de verrouillage répartis autour de la base (110) et généralement alignés avec les au moins quatre brides de coin.

3. Le contenant (100) de la revendication 1, dans lequel :
l'élément de verrouillage (160) définit une partie crochet (185) ayant une surface de came conçue pour venir en prise avec un bord de l'ouverture de la bride de coin flexible (162) de sorte qu'un mouvement conjoint du couvercle (115) et de la bride de coin (162) vers le bas par rapport à la base (110) applique une force à la surface de came pour défléchir l'élément de verrouillage (160) vers un axe central du contenant (100) ;
la bride de coin (162) est conçue et agencée de sorte que la déflexion de la bride de coin (162) par rapport au couvercle (115) amène la partie crochet (185) à dégager l'ouverture et amène le mécanisme de verrouillage à s'encliqueter radialement vers l'extérieur dans une position de verrouillage ; et
la partie de mise en prise de l'élément de verrouillage (160) vient en prise avec la surface supérieure (163) de la bride de coin (162) pour verrouiller le couvercle (115) par rapport à la base (110).

4. Le contenant (100) de la revendication 3, dans lequel la surface de came définit deux parties de surface de came conçues pour venir en prise avec ledit bord d'ouverture, les deux parties de surface de came définissant un espace entre elles.

5. Le contenant (100) de la revendication 1, dans lequel la bride de coin flexible (162) est moulée en une seule pièce avec le couvercle (115).

6. Le contenant (100) de la revendication 1, dans lequel la bride de coin (162) définit une plaque de poussée conçue pour recevoir une force vers le bas pour défléchir la bride de coin (162).

7. Le contenant (100) de l'une quelconque des revendications précédentes, comprenant en outre
une pluralité de supports de substrats (130) conçus pour recevoir une pluralité de substrats dans un empilement de substrats, dans lequel la pluralité de substrats forme la pluralité de substrats empilés, dans le contenant (100).

8. Le contenant (100) de la revendication 7, dans lequel l'empilement de substrats crée une butée dure empêchant le déplacement de la base (110) et du couvercle (115) l'un par rapport à l'autre.

9. Le contenant (100) de la revendication 7, comprenant en outre l'empilement de substrats, et
dans lequel l'empilement de substrats comprend la pluralité de substrats et la pluralité de supports de substrats (130).

10. Le contenant (100) de la revendication 9, dans lequel le couvercle (115) est en contact avec l'empilement de substrats, l'empilement de substrats étant conçu pour empêcher le couvercle (115) de se déplacer vers la base (110) lorsque le couvercle (115) est verrouillé par rapport à la base (110).

11. Le contenant (100) de l'une quelconque des revendications précédentes, dans lequel
l'élément de verrouillage résilient (160) définit une première et une seconde surfaces de mise en prise conçues pour entrer en contact avec des côtés opposés de la bride de coin flexible (162) adjacents à l'ouverture et limiter une flexion de la bride de coin flexible (162) dans des directions opposées.

12. Le contenant (100) de la revendication 11, dans lequel seule une des première et seconde surfaces de mise en prise à la fois peut entrer en contact avec la bride de coin flexible (162) et limiter la flexion de la bride de coin flexible (162) dans une direction respective des directions opposées.

13. Le contenant (100) de la revendication 11, dans lequel lesdits substrats sont des plaquettes de semi-conducteurs.
